## Europäisches Patentamt

## European Patent Office

## Office européen des brevets

(19)

(11) Veröffentlichungsnummer: **0 119 509**
**A1**

(12) # EUROPÄISCHE PATENTANMELDUNG

(21) Anmeldenummer: **84101853.4**

(22) Anmeldetag: **22.02.84**

(51) Int. Cl.³: **H 03 K 13/08**

(30) Priorität: **11.03.83 DE 3308608**

(43) Veröffentlichungstag der Anmeldung: **26.09.84**
**Patentblatt 84/39**

(84) Benannte Vertragsstaaten: **DE FR GB**

(71) Anmelder: **ROBERT BOSCH GMBH, Postfach 50, D-7000 Stuttgart 1 (DE)**

(72) Erfinder: **Volk, Ulrich, Robert-Bosch-Strasse 15, D-7140 Ludwigsburg (DE)**

(54) **Analog/Digital-Wandler.**

(57) Es wird ein Analog/Digital-Wandler vorgeschlagen, der nach dem Parallelverfahren arbeitet. Zur Reduzierung des Bauelementeaufwandes werden den Komparatoren die jeweiligen Referenzspannungen über Addierer zugeführt. Mittels der Addierer läßt sich die Referenzspannung eines Komparators in Abhängigkeit vom Zustand der übrigen höherwertigen Komparatoren verändern. Dadurch wird erreicht, daß sehr wenige Komparatoren notwendig sind und Dekoder bei geeigneter Wahl der Referenzspannungen entfallen können.

EP 0 119 509 A1

R. **18435**                          0119509

9.2.1983 Fd/Jä

ROBERT BOSCH GMBH, 7000 Stuttgart 1


Analog/Digital-Wandler

Stand der Technik

Die Erfindung geht aus von einem Analog/Digital-Wandler
nach der Gattung des Hauptanspruchs. Solche Analog/Digital-Wandler sind beispielsweise aus Tietze, Schenk,
Halbleiterschaltungstechnik, 4. Auflage, Springer-
Verlag Berlin, Heidelberg, New York, Seite 635 ff bekannt.
Die dort gezeigten Analog/Digital-Wandler benötigen für
eine n-Bit Wandlung $(2^n)-1$ Komparatoren und einen zusätzlichen Dekoder. Mit wachsender Auflösung des A/D-Wandlers wächst daher die Zahl der notwendigen Komparatoren
exponentiell. Entsprechend aufwendig wird das Dekodiernetzwerk. Die bekannten Analog/Digital-Wandler sind daher
aufwendig und demzufolge teuer.

Vorteile der Erfindung

Der erfindungsgemäße Analog/Digital-Wandler mit den kennzeichnenden Merkmalen des Hauptanspruchs hat demgegenüber
den Vorteil, daß die Zahl der Komparatoren stark reduziert
ist. Selbst unter Berücksichtigung der zusätzlich benötigten Bauelemente ergibt sich eine deutliche Reduzierung
der elektronischen Bauelemente. Als weiterer Vorteil ist
anzusehen, daß durch geeignete Wahl der Referenzspannungen

...

ein Dekoder nicht erforderlich ist. Der erfindungsgemäße A/D-Wandler ist daher leicht aufzubauen, gut zu prüfen und preisgünstig herstellbar. Als weiterer Vorteil ist zu erwähnen, daß für den A/D-Wandler nur ein Widerstandstyp Verwendung findet, so daß die Schaltungsanordnung auch leicht integriert oder in Verbindung mit Widerständen in Dickschichttechnik aufbaubar ist.

Durch die in den Unteransprüchen aufgeführten Maßnahmen sind vorteilhafte Weiterbildungen und Verbesserungen des im Hauptanspruch angegebenen A/D-Wandlers möglich. Vorteilhaft ist es, den Addierern des jeweiligen Komparators die Referenzspannungen aller höherwertigen Komparatoren über Schalter zuzuführen, die durch den jeweiligen Komparatorausgang schaltbar sind. Durch diese Maßnahme wird erreicht, daß mittels einer einzigen Referenzspannung der gesamte A/D-Wandler betreibbar ist. Die Genauigkeit des Wandlers ist daher nur von dieser Referenzspannung abhängig. Weiterhin ist es vorteilhaft, die Schalter als elektronische Schalter auszubilden. Hierdurch ist ein besonders einfacher Aufbau und eine schnelle Umschaltzeit der Schalter gegeben. Außerdem entfallen mechanische Bauelemente, so daß der A/D-Wandler betriebssicher ist. Günstig ist es, wenn die Referenzspannung für den nachfolgenden Komparator den doppelten Wert der Referenzspannung des vorhergehenden Komparators aufweist. Durch diese Maßnahme wird eine gleichmäßige Auflösung des A/D-Wandlers über den gesamten Wandlungsbereich erzielt. Als weiterer Vorteil ist anzusehen, daß sich an den Ausgängen der Komparatoren von alleine eine BCD- oder Dualstellung ergibt. Für diese beiden Darstellungsarten können daher Dekoder entfallen.

...

18435     - 3 -        0119509

Zeichnung

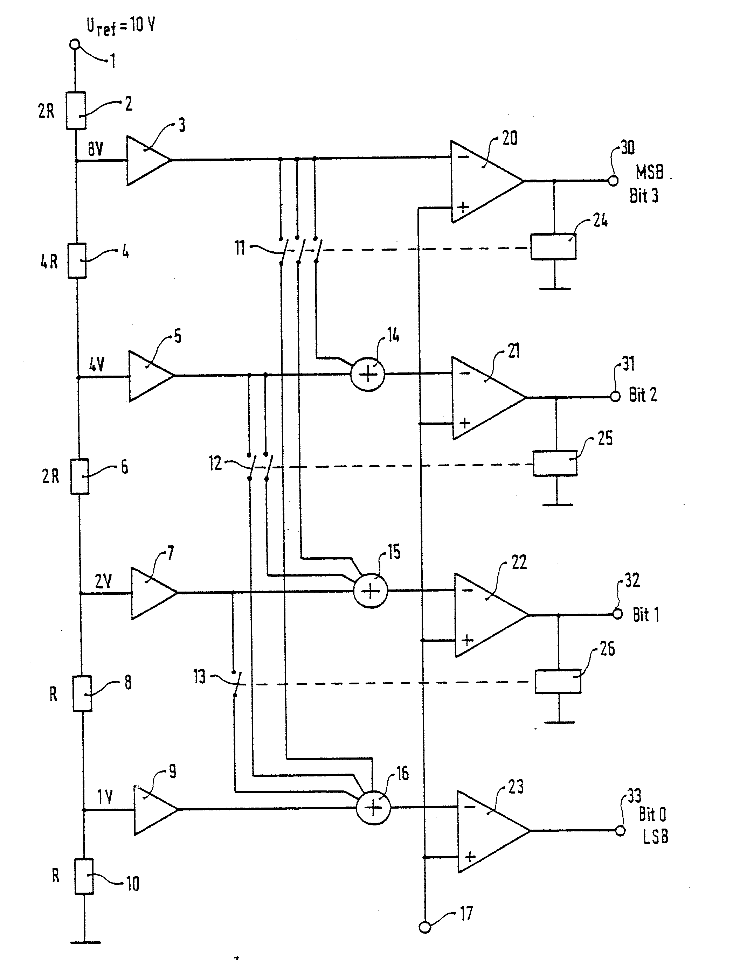

Ein Ausführungsbeispiel der Erfindung ist in der Zeichnung dargestellt und in der nachfolgenden Beschreibung
näher erläutert. Die Figur zeigt einen erfindungsgemäßen Analog/Digital-Wandler.

Beschreibung des Ausführungsbeispiels

Die Figur zeigt einen Referenzspannungseingang 1, an
dem beispielsweise eine Referenzspannung von 10 V angelegt ist. An den Referenzeingang ist ein Widerstand
2 angeschlossen, der beispielsweise den Wert 2 R hat.
Dem Widerstand 2 folgt ein Widerstand 4, der beispielsweise den Wert 4 R aufweist. Zwischen den beiden Widerständen 2 und 4 ist der Eingang eines Spannungsfolgers
3 angeschlossen. Dem Widerstand 4 folgt ein Widerstand
6, der beispielsweise den Wert 2 R hat. Zwischen den
Widerständen 4 und 6 ist wiederum ein Spannungsfolger
5 angeschlossen. Dem Widerstand 6 folgt ein Widerstand
8. Zwischen den Widerständen 6 und 8 führt eine Leitung
zum Eingang eines Spannungsfolgers 7. Dem Widerstand 8
folgt ein Widerstand 10, der wie der Widerstand 8 beispielsweise den Wert R hat. Der andere Anschluß des
Widerstands 10 ist zur gemeinsamen Masseleitung geführt.
Zwischen dem Widerstand 8 und dem Widerstand 10 ist
ein Spannungsfolger 9 angeschlossen.

Der Ausgang des Spannungsfolgers 3 führt zum invertierenden Eingang eines Komparators 20. Weiterhin sind
an den Spannungsfolger 3 drei Leitungen angeschlossen,
die zu einem Schalter 11 führen. Nach dem Schalter 11,
der beispielsweise als elektronischer Schalter mittels

. . .

Feldeffekttransistoren ausgebildet ist, führt jeweils
eine Leitung zu jeweils einem Eingang eines der
Addierer 14, 15 und 16. Der Ausgang des Spannungsfolgers 5 führt zu einem weiteren Eingang des Addierers 14. Der Ausgang des Addierers 14 steht mit
dem invertierenden Eingang eines Komparators 21 in
Verbindung. An den Ausgang des Spannungsfolgers 5
sind zwei Leitungen angeschlossen, die zum elektronischen Schalter 12 führen, der beispielsweise mit
Feldeffekttransistoren ausgeführt ist. Nach dem
elektronischen Schalter 12 führt jeweils eine Leitung zu einem weiteren Eingang der Addierer 15 und 16.
Vom Spannungsfolger 7 führt eine Leitung zu einem
weiteren Eingang des Addierers 15. Der Ausgang des
Addierers 15 steht mit dem invertierenden Eingang
eines Komparators 22 in Verbindung. Weiterhin ist an
den Spannungsfolger 7 eine Leitung angeschlossen, die
über einen elektronischen Schalter 13 zu einem weiteren
Eingang des Addierers 16 geführt ist.

Der Ausgang des Spannungsfolgers 9 führt zu dem vierten
Eingang des Addierers 16, dessen Ausgang mit dem invertierenden Eingang des Komparators 23 verbunden ist. Die
nicht invertierenden Eingänge der Komparatoren 20, 21,
22 und 23 führen zu einem Analogeingang 17. Der Ausgang
des Komparators 23 führt zu einem Ausgang 33, an dem
das Bit 0 oder das niederwertigste Bit (LSB) abgreifbar ist. Der Ausgang des Komparators 22 führt zu einem
Anschluß 32, an dem das Bit 1 des A/D-Wandlers abgreifbar ist. Weiterhin steht der Ausgang des Komparators
22 mit einer Schaltstufe 26 in Verbindung, die zur
Ansteuerung des elektronischen Schalters 13 dient.

...

Der Ausgang des Komparators 21 führt zum Anschluß 31,
an dem das Bit 2 abgreifbar ist. Weiterhin führt der
Ausgang des Komparators 21 zu einer elektronischen Ansteuerschaltung 25 für die elektronischen Schalter 12.
Der Ausgang des Komparators 20 führt schließlich zu
einem Anschluß 30, an dem das Bit 3 als höchstwertiges
Bit (MSB) abgreifbar ist. Weiterhin ist eine elektronische Ansteuerschaltung 24 an den Ausgang des Komparators 20 angeschlossen, die zur Ansteuerung der
elektronischen Schalter 11 dient.

Spannungsfolger, Addierer, Komparatoren und elektronische
Schalter sind als solche bekannt. Als Spannungsfolger
und Addierer eignen sich beispielsweise entsprechend
geschaltete Operationsverstärker vom Typ 4156 der Firma
RAYTHEON. Für die Komparatoren sind die integrierten
Schaltkreise LM 139 der Firma NATIONAL SEMICONDUCTOR
verwendbar, als elektronische Schalter eignen sich
die integrierten Schalter 4066 der Firma RCA.

Die Funktionsweise des in der Figur beispielhaft gezeigten 4 Bit-A/D-Wandlers soll im folgenden näher erläutert werden. Ist die Eingangsspannung am Analogeingang 17 0 V, so sind den vier Komparatoren 20 bis 23
bei geöffneten Analogschaltern 11 bis 13 zunächst
Schaltschwellen zugeordnet, die ihrer jeweiligen Bit-
Wertigkeit entsprechen. Bei der angegebenen Referenzspannung von 10 V und bei der vorgegebenen Widerstandswahl liegen somit am invertierenden Eingang des Komparators 23 1 V, am invertierenden Eingang des Komparators 22 2 V, am invertierenden Eingang des Komparators
21 4 V und am invertierenden Eingang des Komparators 20
8 V an.

...

Wird nunmehr eine Spannung an den Analogeingang 17 angelegt, so schalten zunächst alle Komparatoren, deren
Schwellenspannung kleiner ist als die Eingangsspannung
auf eine logische 1. Dadurch schließen alle diese Komparatoren ihre zugeordneten elektronischen Schalter
und schalten die dem jeweiligen Komparator zugeordnete,
der Bit-Wertigkeit proportionale Spannung auf die
Addierer aller niedrigerwertigen Bits. Dadurch werden
deren Komparator-Schwellspannungen auf die Summe aus
ihrem ursprünglichen Wert und der höherwertigen, auf
logisch 1 befindlichen Bits angehoben.

Nun fallen alle die Komparatoren ab, deren Schwellenspannung nach dieser Addition größer ist als die Eingangsspannung. Das Abfallen dieser Komparatoren bewirkt ein Öffnen der zugeordneten Schalter und somit
fallen die entsprechenden Summanden der niedrigerwertigen Komparatoren wieder weg, so daß sich deren
Schwellenspannungen wieder erniedrigen. Für die niedrigerwertigen Bits beginnt nun der Vorgang von neuem,
bis das least significant Bit (LSB) erreicht ist, dessen
Komparator keine Schalter mehr steuert. Nach diesem
Einschaltvorgang bleibt der Ausgangszustand stabil,
weil von höherwertigen Komparatoren immer nur niedrigerwertige Komparatoren beeinflußt werden können. Die Einschwingzeit für den Analog/Digital-Wandler setzt sich
hierbei aus den Komparatorschaltzeiten, den Addiererlaufzeiten und den Analogschalter-Schaltzeiten zusammen.

Der sich abspielende Einschwingvorgang sei nochmals
an einem konkreten Beispiel erläutert. Steigt beispielsweise die Eingangsspannung am Analogeingang 17 von 0 V
auf 9,2 V an, schalten zunächst alle Komparatoren 20 - 23
auf eine logische 1, da die Eingangsspannung größer als

...

8 V ist. Dadurch schließen die Schalter 11, 12 und 13.
Durch den Addierer 14 erhöht sich die Schaltschwelle
am invertierenden Eingang des Komparators 21 auf 12 V,
durch den Addierer 15 am invertierenden Eingang des
Komparators 22 auf 14 V und durch den Addierer 16 am
invertierenden Eingang des Komparators 23 auf 15 V.
Da die Eingangsspannung kleiner als 12 V ist fallen
die Komparatoren 21, 22 und 23 wiederum ab, während
der Komparator 20 auf einer logischen 1 bleibt, da
die Eingangsspannung größer als 8 V ist. Durch das Abfallen der Komparatoren 21 - 23 öffnen sich ebenfalls
die Schalter 12 und 13, während der Schalter 11 geschlossen bleibt. Dadurch ändert sich die Referenzspannung am Komparator 21 nicht, während die Referenzspannungen am Komparator 22 10 V und am Komparator 23
9 V betragen. Der Komparator 22 bleibt auf einer logischen 0, da seine Referenzspannung nicht erreicht
ist. Der Komparator 23 schaltet wieder um auf eine
logische 1, da die Eingangsspannung geringfügig größer
als die Referenzspannungsquelle des Komparators 23 ist.
Da durch den Komparator 23 keine weiteren Analogschalter
be tätigt werden, bleibt dieser Zustand erhalten. An
den Ausgängen 30 und 33 liegt also eine logische 1
an, während an den Ausgängen 31 und 32 eine logische
0 anliegt. Das abgreifbare Datenwort 1001 entspricht
einer dezimalen 9 im Dual- oder BCD-System.

Der erfindungsgemäße Analog/Digital-Wandler ist
für beliebig hohe Auflösung ausbaubar. Für einen
8 Bit-Wandler werden beispielsweise 8 Komparatoren,
7 Addierer mit insgesamt 35 Eingängen und 28 elektronische Schalter benötigt. Ein Dekodierer ist nicht
erforderlich. Bei bekannten Analog/Digital-Wandlern
sind statt dessen 255 Komparatoren sowie ein Dekoder
für die Ausgänge der 255 Komparatoren erforderlich.

. . .

Sind die Addierer so aufgebaut, daß an ihren offenen
Eingängen stets OV anliegen, so können die Mehrfachebenen-Schalter jeweils zu einem einzelnen Schalter
reduziert werden. Die entsprechenden Addiereingänge
werden dann gemeinsam auf diesen Schalter gelegt. In
diesem Fall beeinflußen sich zusammengeschaltete
Addiereingänge gegenseitig nicht, da eine Addition von
OV keine Ausgangsspannungsänderung an den Addierern
bewirkt. Für eine n-Bit-Wandlung sind dann nur noch
n-1 Analogschalter erforderlich

R. **18435**

9.2.1983 Fd/Jä

0119509

ROBERT BOSCH GMBH, 7000 Stuttgart 1

Ansprüche

1. Analog/Digital-Wandler nach dem Parallelverfahren mit Referenzspannungsquellen und mit Komparatoren, bei denen ein Eingang mit einer Referenzspannungsquelle verbunden ist und ein anderer Eingang zum Analogspannungseingang führt, wobei die Komparatoren umschalten, sobald die analoge Eingangsspannung den Wert der Referenzspannungsquelle des betreffenden Komparators überschreitet, dadurch gekennzeichnet, daß die jeweilige Referenzspannung allen Komparatoren (21 - 23), ausgenommen dem Komparator (20) für das höchstwertige Bit, über Addierer (14 - 16) zugeführt ist und daß den Addierern (14 - 16) der Komparatoren (21 - 23) mit niederwertigerem Bit die Referenzspannungen der Komparatoren (20 - 22) mit höherwertigem Bit zugeführt sind, wenn diese Komparatoren durch die Eingangsspannung geschaltet sind.

2. Analog/Digital-Wandler nach Anspruch 1, dadurch gekennzeichnet, daß dem Addierer (14, 15, 16) des jeweiligen Komparators (21, 22, 23) neben der Bit-wertigen Referenzspannung die Referenzspannungen aller höherwertiger Komparatoren über Schalter (11, 12, 13) zugeführt sind, die durch den jeweiligen Komparatorausgang der höherwertigen Komparatoren (20, 21, 22) schaltbar sind.

...

3. Analog/Digital-Wandler nach Anspruch 2, dadurch gekennzeichnet, daß die Schalter (11, 12, 13) als elektronische Schalter ausgebildet sind.

4. Analog/Digital-Wandler nach einem der Ansprüche 1 bis 3, dadurch gekennzeichnet, daß die Referenzspannung für den höherwertigen, nachfolgenden Komparator (22, 21, 20) den doppelten Wert der Referenzspannung des vorhergehenden Komparators (23, 22, 21) aufweist.

0119509

Europäisches
Patentamt

**EUROPÄISCHER RECHERCHENBERICHT**

0119509
Nummer der Anmeldung

EP 84 10 1853

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| X | US-A-3 100 298 (FLUHR) <br> * Spalte 3, Zeile 25 - Spalte 5, Zeile 30; Figur 1 * <br><br> --- <br><br> | 1,3,4 | H 03 K 13/08 |
| X | US-A-2 950 469 (RAASH) <br> * Spalte 4, Zeile 43 - Spalte 8, Zeile 50; Figuren 2,3 * <br><br> ----- | 1-4 | |

| | RECHERCHIERTE SACHGEBIETE (Int. Cl. 3) |
|---|---|
| | H 03 K 13/08 |

Der vorliegende Recherchenbericht wurde für alle Patentansprüche erstellt.

| Recherchenort <br> DEN HAAG | Abschlußdatum der Recherche <br> 06-06-1984 | Prüfer <br> GUIVOL Y. |
|---|---|---|